# EUROPÄISCHE PATENTSCHRIFT

(11) **EP 1 128 268 B1**
(45) Veröffentlichungstag und Bekanntmachung des Hinweises auf die Patenterteilung: **28.04.2004**
(21) Anmeldenummer: 01102581.4
(22) Anmeldetag: 06.02.2001
(51) Int. Cl.: G06F 11/20, G11C 29/00

(54) **Redundanz-Multiplexer für Halbleiterspeicheranordnung**
Redundancy multiplexer for semiconductor memory device
Multiplexeur de redondance pour mémoire à semi-conducteur

(30) Priorität: 24.02.2000 DE 10008578
(43) Veröffentlichungstag der Anmeldung: 29.08.2001
(73) Patentinhaber: Infineon Technologies AG, 81669 München (DE)
(72) Erfinder: Nygren, Aaron, 81667 München (DE)
(74) Vertreter: Müller - Hoffmann & Partner

(56) Entgegenhaltungen:
- US-A- 4 566 081
- US-A- 4 601 019

## Beschreibung

Die vorliegende Erfindung betrifft einen Redundanz-Multiplexer für eine Halbleiterspeicheranordnung zum Ersetzen einer fehlerhaften Bitleitung durch eine redundante Bitleitung, bei dem aus in Fuses abgespeicherter Information, welche Bitleitung zu ersetzen ist, in einem Decoder ein Steuersignal erzeugt wird, und bei dem zwei Redundanz-Bereiche mit der redundanten Bitleitung beidseitig zu einem Zentralbus von dem Steuersignal auswählbar sind.

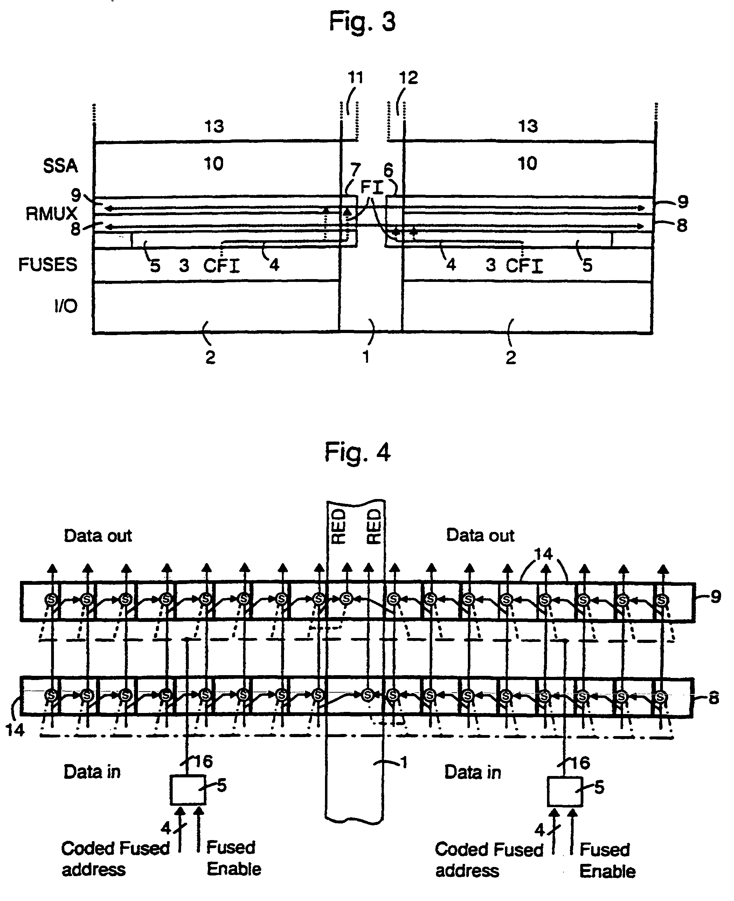

Fig. 3 zeigt den Aufbau eines herkömmlichen Redundanz-Multiplexers für eine Halbleiterspeicheranordnung. Beidseitig von einem Zentralbus bzw. Zentralbereich 1 ist eine Eingabe/Ausgabeeinheit (I/O) 2 vorgesehen, in die Information eingegeben wird, welche Bitleitung fehlerhaft ist und durch eine redundante Bitleitung ersetzt werden muß. Dabei können selbstverständlich so viele Bitleitungen durch redundante Bitleitungen ersetzt werden, wie redundante Bitleitungen insgesamt vorhanden sind. Diese Information über fehlerhafte Bitleitungen wird in Fuses (FUSES) 3 abgelegt, so daß hier codierte Fuse-Information CFI vorliegt, die angibt, welche Bitleitungen fehlerhaft sind und durch redundante Bitleitungen ersetzt werden müssen. Es sei nun angenommen, daß diese codierte Fuse-Information CFI auf jeder Seite des Zentralbusses 1 über einen entsprechenden, schematisch durch eine Punktlinie angedeuteten Fuse-Bus 4 über einen Puffer und Decoder 5, der decodierte Fuse-Information FI liefert, direkt oder über beim Lesen oder Schreiben verwendete Steuereinheiten 6, 7 zu einem Redundanz-Multiplexer (RMUX) 8, 9 abgegeben wird. Beispielsweise wird also von den in Fig. 3 rechts von dem Zentralbus 1 gelegenen Fuses 3 die codierte Fuse-Information CFI über den Puffer und Decoder 5, der daraus die decodierte Fuse-Information FI erzeugt, zu der Steuereinheit 6 gesandt und von dieser über der gesamten Schnittstellenbreite des Redundanz-Multiplexers 9 mit Leseverstärkern (SSA) 10 verteilt, bevor die zugehörige redundante Bitleitung in einem Bereich 11 neben dem Speicherzellenfeld 13 angesteuert wird.

Ein derartiges Vorgehen zur Auswahl redundanter Bitleitungen ist unproblematisch, solange die Schnittstellenbreite zwischen den Redundanz-Multiplexern 8, 9 und den Leseverstärkern 10 bzw. dem Speicherzellenfeld 13 relativ schmal ist. Mit zunehmender Schnittstellenbreite, wie beispielsweise bei einem 128 Bit eDRAM, bauen sich jedoch durch die größere Schnittstellenbreite Zeitverzögerungen auf, die ein ernsthaftes Problem darstellen: wie schematisch in Fig. 3 gezeigt ist, müssen die Steuersignale zur Ansteuerung jeder redundanten Bitleitung die gesamte Breite der Schnittstelle durchlaufen, so daß die Fuse-Information CFI bzw. FI sich über maximal 3/4 der Schnittstellenbreite ausbreiten muß. Beispielsweise muß die Fuse-Information CFI bzw. FI aus dem in Fig. 3 links von dem Zentralbus 1 gelegenen Bereich 3 der Fuses (vgl. Punktlinie 4) zu der Steuereinheit 7 laufen und dann von dort sich bis zum rechten oder linken Rand des Redundanz-Multiplexers 9 ausbreiten, bis der zur redundanten Bitleitung im Bereich 11 gehörige Leseverstärker 10 gefunden ist.

Diese Zeitverzögerung ist letztlich dadurch bedingt, daß die Ansteuerungen der redundanten Bitleitungen im Bereich 11 für den Redundanz-Multiplexer 9 und im Bereich 12 für den Redundanz-Multiplexer 8 über die gesamte Breite der Schnittstelle beidseitig von dem Zentralbus 1 erfolgt.

Um also eine maximale Anzahl von Reparaturmöglichkeiten fehlerhafter Bitleitungen durch redundante Bitleitungen aufrechtzuerhalten, sind bei der üblichen Anordnung zwangsläufig lange Verzögerungszeiten vorhanden, die durch die Ausbreitung der Steuersignale über 3/4 der Schnittstellenbreite bedingt sind.

Fig. 4 zeigt den Aufbau des bestehenden Redundanz-Multiplexers 8 bzw. 9 von Fig. 3 in Einzelheiten: ausgehend von einem Decoder 5, der beidseitig von dem Zentralbus 1 angeordnet ist und Information von fünf Fuses 3 empfängt (vier Fuses für Adreß-Information "Coded Fused address" und eine Fuse für "Fused Enable"), werden 16 Schaltersignale jeweils beidseitig von dem Zentralbus 1 zur Ansteuerung von jeweils 16 Schaltern 14 des Redundanz-Multiplexers 8 (für den in Fig. 4 rechten Decoder 5) bzw. des Redundanz-Multiplexers 9 (für den in Fig. 4 linken Decoder 5) geliefert.

Abhängig von diesen Schaltersignalen werden die in die Schalter 14 eingegebenen Daten ("Data in") durch die Schalter 14 der Redundanz-Multiplexer 8, 9 weitergeleitet ("Data out"), um so gegebenenfalls redundante Bitleitungen beispielsweise im Bereich des Zentralbusses 1 anzusteuern, wie dies in Fig. 4 schematisch durch "RED" angedeutet ist.

Dieses bestehende Konzept kann als unilateral bezeichnet werden, da für die Redundanz-Multiplexer 8, 9 zwischen den beiden Seiten des Zentralbusses 1 nicht unterschieden wird und die Redundanz-Multiplexer 8, 9 für den Zentralbus 1 und damit auch für die gesamte Schnittstellenbreite "unilateral" sind.

Dokument US-A-4 601 019 offenbart eine Halbleiterspeicheranordnung gemäß dem Oberbegriffs des Anspruchs 1.

Es ist nun Aufgabe der vorliegenden Erfindung, einen Redundanz-Multiplexer zu schaffen, der die durch die unilaterale Struktur bedingten Verzögerungszeiten bei der Ausbreitung der Schaltsignale vermeidet und sich somit durch verkürzte Ausbreitungszeiten für diese Schaltsignale auszeichnet.

Diese Aufgabe wird gemäß Patentanspruch 1 bei einem Redundanz-Multiplexer der eingangs genannten Art erfindungsgemäß dadurch gelöst, daß der Decoder das Schalt- bzw. Steuersignal jeweils nur zu auf einer Seite des Zentralbusses gelegene Zonen der beiden Redundanzbereiche liefert.

Der erfindungsgemäße Redundanz-Multiplexer sieht damit ein bilaterales Konzept vor. Die im Decoder decodierte Fuse-Information wird lediglich in Steuer- bzw. Schaltsignalen auf einer Seite des Zentralbusses ausgewertet, wodurch sich die Entfernung, über die sich diese Signale ausbreiten müssen, auf 1/4 der Schnittstellenbreite reduzieren läßt. Mit anderen Worten, die Signalausbreitungszeit ist um einen Faktor 3 verringert. Das heißt, Fuse-Information für den Decoder und die vom Decoder gelieferten Schalt- bzw. Steuersignale verbleiben auf der einen oder anderen Seite des Zentralbusses. Da aber das Codieren der in die Eingabe/Ausgabeeinheit eingegebenen Information in den Fuses und das Decodieren dieser Information im Puffer und Decoder insgesamt erfolgen, kann eine fehlerhafte Bitleitung in einer Hälfte der Anordnung, also auf der einen Seite des Zentralbusses, durch eine redundante Bitleitung auf der anderen Seite dieses Zentralbusses ersetzt werden, so daß alle "Reparaturmöglichkeiten" offen gehalten werden. Mit anderen Worten, die Funktionalität dieses "bilateral" ausgerichteten Konzeptes ist gleichwertig zu dem unilateralen Konzept, weist jedoch den Vorteil einer kürzeren Verzögerungszeit für die Steuer- bzw. Schaltsignale auf, da nur eine Entfernung von 1/4 anstelle von 3/4 der Schnittstellenbreite zu überwinden ist.

In einem praktischen Beispiel kann die Schnittstellenbreite etwa 3 mm betragen. Beim unilateralen Konzept ist dann eine Ausbreitung der Schalt- bzw. Steuersignale über eine Entfernung von 2,25 mm erforderlich, während das bilaterale Konzept gemäß der vorliegenden Erfindung nur noch eine Entfernung von etwa 0,75 mm für die Ausbreitung der Signale erfordert.

Durch diese kürzeren Leitungen bzw. Signalwege ist die Kapazität reduziert, was neben verringerten Ausbreitungszeiten auch den Einsatz von kleineren Ansteuergliedern bzw. Drivern ermöglicht.

Nachfolgend wird die Erfindung anhand der Zeichnungen näher erläutert. Es zeigen:
- Fig. 1: ein schematisches Schaltbild zur Erläuterung des erfindungsgemäßen Redundanz-Multiplexers für eine Halbleiterspeicheranordnung,
- Fig. 2: den Redundanz-Multiplexer von Fig. 1 in Einzelheiten,
- Fig. 3: ein schematisches Schaltbild eines bestehenden Redundanz-Multiplexers für eine Halbleiterspeicheranordnung und
- Fig. 4: den Redundanz-Multiplexer von Fig. 3 in Einzelheiten.

Die Fig. 3 und 4 sind bereits eingangs erläutert worden.

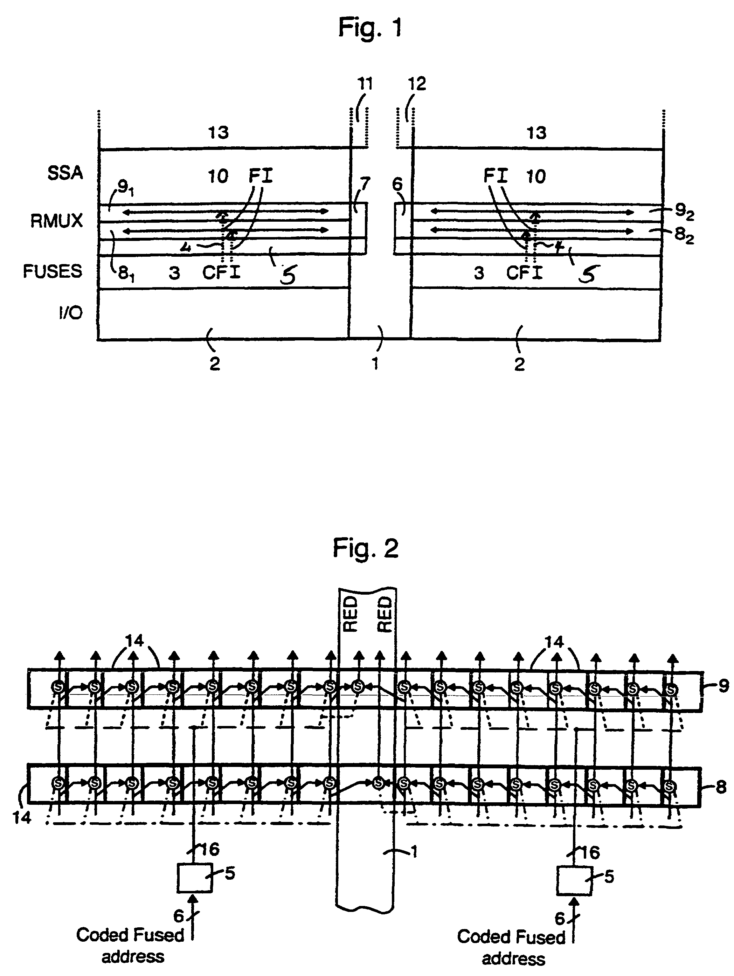

In den Fig. 1 und 2 werden einander entsprechende Bauteile mit den gleichen Bezugszeichen wie in den Fig. 3 und 4 versehen und nicht näher erläutert.

Fig. 1 zeigt ein Ausführungsbeispiel für den erfindungsgemäßen Redundanz-Multiplexer, der sich in einem wesentlichen Punkt von dem bestehenden Redundanz-Multiplexer gemäß Fig. 3 unterscheidet: die codierte Fuse-Information CFI, die von den Fuses 3 über den Puffer und Decoder 5 geliefert ist, wird "bilateral" zu den Redundanz-Multiplexern 8 und 9 so gesandt, daß sich die Schalt- bzw. Steuersignale jeweils nur noch auf einer Seite des Steuerbusses 1 ausbreiten: der Redundanz-Multiplexer 9₁ erhält die Fuse-Information FI von dem Decoder 5 für Redundanz-Bitleitungen im Bereich 11, während der Redundanz-Multiplexer 8₁ die Fuse-Information FI von dem Decoder 5 für Redundanz-Bitleitungen im Bereich 12 empfängt. In ähnlicher Weise erhält der Redundanz-Multiplexer 9₂ die Fuse-Information FI von dem Decoder 5 für Redundanz-Bitleitungen im Bereich 12, während dem Redundanz-Multiplexer 8₂ Fuse-Information FI vom Decoder 5 für Redundanz-Bitleitungen im Bereich 11 zugeführt ist.

Auf diese Weise wird die Ausbreitungsentfernung, über die sich die Schalt- bzw. Steuersignale ausbreiten müssen, auf 1/4 der Schnittstellenbreite reduziert, wie dies sofort aus dem schematischen Schaltbild von Fig. 1 zu ersehen ist. Das heißt, die Ausbreitungszeit für die Schalt- bzw. Steuersignale kann um einen Faktor 3 reduziert werden.

Fig. 2 zeigt noch ähnlich wie Fig. 4 die Zuordnung der Decoder 5 zu einzelnen Schaltern 14 der Multiplexer 8 (8₁ und 8₂) bzw. 9 (9₁, 9₂). Hier sind im Gegensatz zu den 16 Kombinationen der Anordnung von Fig. 4 insgesamt 32 Kombinationen möglich, da jeder Decoder 5 Schalter 14 in beiden Multiplexern 8 und 9 versorgt. Daher werden hier dem Decoder 5 jeweils sechs Adreßsignale ("Coded Fused address") zugeführt, wie dies in Fig. 2 angedeutet ist. Auf ein "Enable"-Signal kann hier verzichtet werden.

Während mit der bestehenden Anordnung nach Fig. 4 jeder Decoder 5 mit jeweils einem Redundanz-Multiplexer 8 bzw. 9 eine Redundanz-Bitleitung zur Reparatur einer fehlerhaften Bitleitung zuschalten kann, ist es möglich, mit dem erfindungsgemäßen Redundanz-Multiplexer, wie dieser in den Fig. 1 und 2 veranschaulicht ist, mittels jedes Multiplexers 8₁, 8₂ und 9₁, 9₂ jeweils eine Redundanz-Bitleitung einzuschalten, so daß hier jeder Decoder 5 zwei fehlerhafte Bitleitungen zu reparieren vermag.

## Patentansprüche

1. Redundanz-Multiplexer für Halbleiterspeicheranordnung zum Ersetzen einer fehlerhaften Bitleitung durch eine redundante Bitleitung, bei dem aus in Fuses (3) abgespeicherter Information (CFI), welche Bitleitung zu ersetzen ist, in einem Decoder (5) ein Steuer- bzw. Schaltsignal erzeugt wird,
**dadurch gekennzeichnet, dass**
ein erster Redundanz-Bereich (8) mit ersten redundanten Bitleitungen in einem ersten Bereich (11) auf einer ersten Seite eines Zentralbusses (1) und ein zweiter Redundanz-Bereich (9) mit zweiten redundanten Bitleitungen in einem zweiten Bereich (12) auf einer zweiten zur ersten Seite gegenüberliegenden Seite des Zentralbusses (1) von dem Steuer- bzw. Schaltsignal auswählbar sind, und
die in den Fuses (3) abgespeicherte Information (CFI) über den Decoder (5) zu den beiden Redundanz-Bereichen (8, 9) so bilateral gesandt ist, dass sich die Steuer- bzw. Schaltsignale jeweils nur noch auf einer Seite des Zentralbusses (1) ausbreiten und die auf der ersten bzw. zweiten Seite des Zentralbusses (1) gelegenen Teile der ersten und zweiten Redundanz-Bereiche (8, 9) mittels der Steuer- bzw. Schaltsignale nur noch von dem Decoder (5) decodierte Fuse-Information (FI) für redundante Bitleitungen im ersten bzw. zweiten Bereich (11, 12) empfangen, und sodass die Ausbreitungszeit des Steuer- bzw. Schaltsignales durch den Signalweg über die Hälfte des auf einer Seite des Zentralbusses (1) gelegenen Teiles des ersten bzw. zweiten Redundanz-Bereiches (8, 9) und damit durch 1/4 der Schnittstellenbreite des Redundanz-Multiplexers gegeben ist.

2. Redundanz-Multiplexer nach Anspruch 1
**dadurch gekennzeichnet, dass**
mit jedem Teil (8₁, 9₁; 8₂, 9₂) der beiden Redundanzbereiche (8, 9) zu jeder fehlerhaften Bitleitung wenigstens eine redundante Bitleitung (11, 12) zuschaltbar ist.

## Claims

1. Redundancy multiplexer for a semiconductor memory arrangement for replacing a faulty bit line with a redundant bit line, in which a control or switching signal is generated in a decoder (5) from information (CFI), stored in fuses (3), about which bit line is to be replaced,
**characterized in that**
a first redundancy area (8) containing first redundant bit lines in a first area (11) on a first side of a central bus (1) and a second redundancy area (9) containing second redundant bit lines in a second area (12) on a second side, opposite the first side, of the central bus (1) can be selected by the control or switching signal, and
the information (CFI) stored in the fuses (3) is transmitted via the decoder (5) to the two redundancy areas (8, 9) bilaterally such that the control or switching signals now propagate only on one side of the central bus (1) in each case, and those parts of the first and second redundancy areas (8, 9) which are situated on the first or second side of the central bus (1) now receive, by means of the control or switching signals, only fuse information (FI), decoded by the decoder (5), for redundant bit lines in the first or second area (11, 12), and so that the propagation time of the control or switching signal depends on the signal path via half of that part of the first or second redundancy area (8, 9) which is situated on one side of the central bus (1), and hence on 1/4 of the interface width of the redundancy multiplexer.

2. Redundancy multiplexer according to Claim 1 ,
**characterized in that**
each part (8₁, 9₁; 8₂, 9₂) of the two redundancy areas (8, 9) can be used to connect at least one redundant bit line (11, 12) for each faulty bit line.

## Revendications

1. Multiplexeur de redondance pour des dispositifs de mémoire à semi-conducteurs en vue de remplacer une ligne de bits défectueuse par une ligne de bits redondante, dans lequel il est produit un signal de commande ou de commutation dans un décodeur simple à partir de l'information (CFI) mémorisée dans des fusibles (3) et indiquant la ligne de bits à remplacer,
**caractérisé en ce que**,
une première zone (8) de redondance ayant des premières lignes de bits redondantes dans une première zone (11) sur un premier côté d'un bus (1) central et une deuxième zone (9) de redondance ayant des deuxièmes lignes de bits redondantes dans une deuxième zone (12) sur un deuxième côté opposé au premier côté du bus (1 ) central peuvent être sélectionnées par le signal de commande ou de commutation et
l'information (CFI) mémorisée dans les fusibles (3) est envoyée bilatéralement par le décodeur (5) aux deux zones (19) de redondance de façon à ce que les signaux de commande ou de commutation ne se propagent respectivement que d'un côté du bus (1) central et les parties, placées du premier ou du deuxième côté du bus (1) central, des première et deuxième zones (8, 9) de redondance ne reçoivent au moyen des signaux de commande ou de commutation que l'information (FI) de fusible décodée par le décodeur (5) pour des lignes de bits redondantes dans la première ou la deuxième zone (11, 12) et de façon à ce que le temps de propagation du signal de commande ou de commutation soit donné par le trajet du signal sur les moitiés de la partie, placée d'un côté du bus (1) central, de la première ou de la deuxième zone (8, 9) de redondance et ainsi par un quart de la largueur d'interface du multiplexeur de redondance.

2. Multiplexeur de redondance suivant la revendication 1, **caractérisé en ce qu'**au moins une ligne (11, 12) de bit redondante peut être raccordée à chaque ligne de bit défectueuse par chaque partie (8₁, 9₁, 8₂, 9₂) des deux zones (8, 9) de redondance.
